# EUROPÄISCHE PATENTSCHRIFT

(11) **EP 2 922 374 B1**
(45) Veröffentlichungstag und Bekanntmachung des Hinweises auf die Patenterteilung: **21.11.2018**
(21) Anmeldenummer: 15157922.4
(22) Anmeldetag: 06.03.2015
(51) Int. Cl.: H05K 7/18, H02B 1/30

(54) **VERKLEIDUNGSELEMENT UND VERFAHREN ZUR HERSTELLUNG EINES VERKLEIDUNGSELEMENT**
CLADDING ELEMENT AND A METHOD FOR PRODUCING A CLADDING ELEMENT
ÉLÉMENT DE REVÊTEMENT ET PROCÉDÉ DE FABRICATION D'UN ÉLÉMENT DE REVÊTEMENT

(30) Priorität: 07.03.2014 DE 102014103047
(43) Veröffentlichungstag der Anmeldung: 23.09.2015
(73) Patentinhaber: Bader GmbH Gehäusebau, 87727 Babenhausen (DE)
(72) Erfinder: Krenn, Josef, 89269 Vöhringen (DE)
(74) Vertreter: Baur & Weber Patentanwälte PartG mbB

(56) Entgegenhaltungen:
- EP-A2- 0 308 715
- DE-A1- 4 300 249
- DE-A1- 10 020 068
- GB-A- 2 345 925

## Beschreibung

Die Erfindung betrifft ein Verkleidungselement, insbesondere ein Verkleidungselement für eine Maschinenverkleidung oder einen Schaltschrank. Darüber hinaus betrifft die Erfindung ein Verfahren zur Herstellung eines solchen Verkleidungselements.

Aus dem allgemeinen Stand der Technik ist es bekannt, beispielsweise aus einem Blechmaterial gefertigte Paneele als Verkleidung für Maschinen oder für Schaltschränke vorzusehen. Derartige Verkleidungen können beispielsweise geschraubt oder über ein Schienensystem beweglich um das zu verkleidende Objekt herum angeordnet sein.

Aus der GB 2 345 925 A ist ein Türpaneel bekannt, welches beispielsweise bei Elektroverteilerschränken verwendet werden kann. Das Türpaneel umfasst eine Grundfläche aus Metallblech, welche an gegenüberliegenden Längsseiten derart verformt ist, dass jeweils Hohlräume entstehen. Durch diese Hohlräume wird die Torsionssteifigkeit des Türpaneels gesteigert.

Aus der DE 100 20 068 A1 ist ein Verfahren zur Herstellung eines Kastens aus Blech bekannt, bei dem ein Blechzuschnitt entlang einer Biegekante mit schmalen Schlitzen und Löchern derart perforiert wird, dass die Löcher und Schlitze nach dem Umbiegen mit einem Beschichtungsmaterial abdichtend verschlossen werden können.

Aus der DE 88 03 330 U1 ist eine Kabine bekannt, die als Maschinenverkleidung aus einzelnen im Baukastensystem aneinander gesetzten Wandelementen besteht. Dabei sind das Material und die Wandstärke der Wandelemente so gewählt, dass die Wandelemente durch Abkanten verformbar sind. Die Wandelemente weisen an ihren den benachbarten Wandelementen zugekehrten Rändern nach innen gerichtete Abkantungen auf. Über die so entstehenden aneinander anliegenden Abkantungen sind benachbarte Wandelemente miteinander verbunden.

Aus der DE 20 2005 021 903 U1 ist eine Verkleidungsanordnung mit wenigstens einer entlang einer Schienenanordnung geführt verfahrbaren Schiebetür bekannt. Die Höhe der Schienenanordnung ist gering gegen die Höhe der Schiebetür, wobei eine türseitige Wagenanordnung eine erste Gruppe von Rollen mit horizontalen Achsen und eine zweite Gruppe von Rollen mit vertikalen Achsen enthält. Jede Gruppe weist mehrere in Verfahrrichtung beabstandete Rollen auf, welche in Führungsbahnen der Schienenanordnung laufen. Die zweite Gruppe von Rollen weist zwei vertikal beabstandete Teilgruppen mit jeweils mehreren Rollen auf, wobei für die beiden Teilgruppen eine eigene obere und untere Führungsbahn in der Schienenanordnung vorliegen. Die Rollen der Teilgruppen sind bezüglich der Rollenachsen radial in den Führungsbahnen abgestützt.

Bekannte Verkleidungsanordnungen weisen jedoch den Nachteil auf, dass zum Erreichen einer ausreichenden Stabilität des Wandpaneels entsprechende Stützelemente vorgesehen sein müssen, die beispielsweise in Form eines Hutprofils entlang der Seitenränder des Verkleidungselements üblicherweise mittels Schweißen angebracht werden müssen. Das Anschweißen eines derartigen Profils führt jedoch zu einem gewissen Wärmeeintrag in das flächenhafte Blechpaneel, so dass eventuell eine Deformation auftritt, die sich beispielsweise in Form von Verbiegungen oder Verwerfungen äußern könnte. Daher sind nach Fertigstellung der Schweißverbindung oder bereits während des Schweißens umfangreiche Richtarbeiten nötig, um anschließend ein flächenhaft ausgebildetes Wandpaneel erhalten zu können.

Darüber hinaus führt der Vorgang des Schweißens selbst zu Verunreinigungen an der Oberfläche des Wandpaneels, die sich beispielsweise durch Verzunderungen oder ähnlichem äußern können. Derartige Schweißrückstände werden üblicherweise nach Fertigstellung der Schweißverbindung durch eine geeignete Prozessführung naßchemisch entfernt, so dass die Wandpaneele in optisch ansprechender Form vorliegen. Aufgrund der hutförmig ausgebildeten Versteifungsprofile können sich jedoch entsprechende wässrige Reinigungsrückstände innerhalb des dadurch gebildeten Hohlkörpers sammeln, die sich in vielen Fällen nur schwer wieder entfernen lassen. Insbesondere bei der anschließenden Lackierung oder Pulverbeschichtung können dann wässrige Rückstände wieder austreten, was zu Farbveränderungen oder fehlenden Beschichtungen an der Oberfläche der Wandpaneele führen kann. In diesem Fall sind umfangreiche Nachbearbeitungen nötig, die die Kosten zur Herstellung der Wandpaneele weiter erhöhen.

Es ist daher Aufgabe der Erfindung, ein Verkleidungselement zu schaffen bzw. ein Verfahren zur Herstellung eines Verkleidungselements anzugeben, das die o. g. Nachteile überwinden und darüber hinaus die Schaffung von Verstärkungselementen innerhalb einer Wandverkleidung ermöglichen, die kostengünstig und ohne größeren Aufwand herstellbar ist.

Diese Aufgabe wird durch die Merkmale der unabhängigen Patentansprüche gelöst. Vorteilhafte Weiterbildungen der Erfindung sind in den Unteransprüchen angegeben. Diese können in technologisch sinnvoller Weise miteinander kombiniert werden. Die Beschreibung, insbesondere im Zusammenhang mit der Zeichnung, charakterisiert und spezifiziert die Erfindung zusätzlich.

Gemäß der Erfindung wird in einem ersten Aspekt ein Verkleidungselement, insbesondere für eine Maschinenverkleidung oder einen Schaltschrank, beschrieben, das ein metallisches Flächenelement aufweist, wobei das Flächenelement wenigstens entlang eines Seitenrands so geformt ist, dass ein Verstärkungselement gebildet ist, das einen Hohlraum umschließt, wobei eine durch Abkanten gebildete erste Biegekante das Flächenelement seitlich begrenzt und eine durch Abkanten gebildete zweite Biegekante auf einer Rückseite des Flächenelements angeordnet ist, wobei zwischen der ersten Biegekante und der zweiten Biegekante eine Perforation im Flächenelement als manuelle Biegekante gebildet ist.

Das erfindungsgemäße Verkleidungselement weist an wenigstens einem Seitenrand ein Verstärkungselement auf, das in Form eines Hohlraums gebildet wird. Im Gegensatz zur bisherigen Lösung mit einem angeschweißten Hutprofil ist bei dem erfindungsgemäßen Verkleidungselement eine Herstellung mittels einer Kombination aus maschinellem und manuellem Biegen möglich, so dass die ansonsten übliche Reinigung entlang von Schweißnähten zur Befestigung des Hutprofils entfallen kann. Das Verstärkungselement wird durch Abkanten sowohl entlang von mechanischen Biegekanten als auch durch ein manuelles Abkanten entlang einer durch Perforation gebildeten Biegekante ermöglicht. Da das Verstärkungselement ohne Anschweißen zusätzlicher Teile gebildet werden kann, verringert sich insbesondere die eingangs geschilderte Problematik der durch wärmeinduzierten Verspannungen, so dass das erfindungsgemäße Verkleidungselement auf einfache Weise herstellbar ist. Aufwändige Ausrichtungen bzw. ein aufwändiges Einspannen in Richtbänke können entfallen. Da keine Reinigungsvorgänge bei der Herstellung des Verkleidungselements auftreten, wird auch die Gefahr, dass Reste von Reinigungsflüssigkeiten während nachfolgender Produktionsschritte, wie z. B. Lackieren oder Pulverbeschichten zu Problemen führen könnten, weitestgehend vermieden. Die Erfindung ermöglicht somit ein Verkleidungselement zu schaffen, das kostengünstig herstellbar ist, aber dennoch eine ausreichende mechanische Stabilität aufweist, so dass es sich für vielerlei Anwendungen eignet.

Gemäß einer Ausführungsform der Erfindung schließt sich der zweiten Biegekante eine dritte Biegekante an, so dass eine streifenförmige Fortsetzung parallel zu einer Hauptfläche des Flächenelements angeordnet ist.

Gemäß dieser Vorgehensweise wird eine streifenförmige Fortsetzung geschaffen, die sich ebenfalls mittels mechanischen Abkantens bilden läßt. Dazu wird parallel zur zweiten Biegekante die dritte Biegekante angeordnet, so dass ein Bereich entsteht, in dem die streifenförmige Fortsetzung parallel zu einer Hauptfläche des Flächenelements angeordnet ist. In diesem Überlappbereich kann somit eine Verbindung zwischen den beiden Flächen vorgenommen werden. Dabei kann die Fortsetzung nicht nur in Form eines Streifens ausgebildet sein, es ist auch möglich, beispielsweise trapezförmige oder dreieckförmige Ausführungen vorzusehen, wobei andere Ausführungen nicht ausgeschlossen sind.

Gemäß einer weiteren Ausführungsform der Erfindung sind die erste Biegekante, die zweite Biegekante, die manuelle Biegekante und gegebenenfalls die dritte Biegekante im Wesentlichen parallel zueinander angeordnet, so dass sich ein rechteckförmiger Hohlraum bildet.

Die Biegekanten werden vorteilhafterweise parallel zueinander angeordnet, so dass sich ein rechteckförmiger Hohlraum bildet. Es ist aber auch möglich, den Hohlraum beispielsweise mit einem anderen Querschnitt, insbesondere einem trapezförmigen Querschnitt auszubilden.

Gemäß einer weiteren Ausführungsform der Erfindung ist die Perforation im Flächenelement mittels eines Lasers gebildet.

Durch das Bilden der Perforation im Flächenelement mittels eines Lasers wird auf einfache Weise eine scharnierartige Biegekante bereit gestellt, entlang derer ein manuelles Abkanten möglich ist. Die Perforation kann dabei entsprechend der benötigten mechanischen Stabilität gewählt werden, wobei Größe bzw. der Abstand der Perforationslöcher zueinander auch in Abhängigkeit der Dicke des Flächenelements gewählt werden kann. Desweiteren ist es auch denkbar, beispielsweise eine Perforation mit unterschiedlichen Lochdurchmessern vorzusehen.

Es ist gemäß der Erfindung vorteilhaft, die Verstärkungselemente entlang des gesamten Außenumfangs auszubilden. Dies ermöglicht die Verwendung des erfindungsgemäßen Verkleidungselements im Rahmen einer Vielzahl von Anwendungen, wobei sowohl die Größe als auch die Form des Verkleidungselements entsprechend gewählt werden können.

Gemäß einer weiteren Ausführungsform der Erfindung sind die erste Biegekante und die zweite Biegekante maschinell abkantbar.

Gemäß dieser Vorgehensweise sind die erste und die zweite Biegekante maschinell abkantbar, was die Produktion des erfindungsgemäßen Verkleidungselements erleichtert. Die Kombination aus manuellen und maschinellen Kanten ermöglicht es, das Verstärkungselement als Hohlprofil auszubilden, wobei auf vorteilhafte Weise die maschinellen Abkantungsschritte zuerst vorgenommen werden, so dass das Verstärkungselement anschließend manuell geschlossen werden kann. Eine derartige Vorgehensweise ist rein maschinell nicht durchführbar, da das bei der Abkantung benötigte Werkzeug den so gebildeten Hohlraum nicht mehre verlassen könnte. Maschinelles Abkanten kann beispielsweise mittels einer Biegepresse, einer Gesenkbiegepresse oder einer Abkantpresse durchgeführt werden.

Gemäß einer weiteren Ausführungsform der Erfindung ist das Verstärkungselement auf der Rückseite des Verkleidungselements mit einer Schienenanordnung vorzugsweise über eine Schraubverbindung verbindbar.

Die Verstärkungselemente auf der Rückseite des Verkleidungselements können auch mit weiteren Vorrichtungen verbunden werden und als Träger für diese fungieren. Hierzu zählen beispielsweise Schiebeanordnungen, Scharniere oder andere dem Fachmann bekannte Befestigungsmittel, die es ermöglichen, das erfindungsgemäße Verkleidungselement beweglich beispielsweise an einem Schaltschrank oder einer Maschinenverkleidung anzuordnen.

Gemäß einer weiteren Ausführungsform der Erfindung ist das Verkleidungselement als einstückiges Blechbauteil bereitgestellt.

Das Verkleidungselement wird vorteilhafterweise einstückig in Form eines Blechbauteils bereitgestellt, wobei Größe und Dicke des Blechbauteils je nach Anwendungsfall beliebig gewählt werden können.

Gemäß einer weiteren Ausführungsform der Erfindung ist im Bereich der zweiten Biegekante und/oder der dritten Biegekante mittels eines Verbindungsverfahrens, insbesondere mittels Punktschweißens eine Verbindung des Verstärkungselements zum Flächenelement herstellbar.

Das entlang der Biegekanten geschlossene Hohlprofil des Verstärkungselements kann auf der Rückseite vorzugsweise entlang der streifenförmigen Fortsetzung mit dem Flächenelement verbunden werden. Neben Kleben bietet sich insbesondere ein Punktschweißverfahren an, so dass eine dauerhafte Verbindung des Verstärkungselements zum Flächenelement entsteht. Andere dem Fachmann bekannte stoffschlüssige Verbindungsverfahren sind jedoch nicht ausgeschlossen. Im Gegensatz dazu wird im Stand der Technik ein Hutprofil beispielsweise mittels eines Lochschweißverfahrens oder einer Verbindung entlang der Nahtstelle an den Außenkanten des Profils mit dem Verkleidungselement verbunden, was zu den eingangs erwähnten Verspannungen führen kann und darüber hinaus aufwändige Reinigungsschritte erforderlich macht. Beim Punktschweißen ist jedoch der Wärmeeintrag nur sehr gering, so dass keine Verspannungen auftreten können, die aufwändige Richtarbeiten erforderlich machen würden.

Gemäß der Erfindung wird in einem zweiten Aspekt ein Verfahren zur Herstellung eines Verkleidungselements, insbesondere für eine Maschinenverkleidung oder einen Schaltschrank, bei dem folgende Schritte ausgeführt werden:
- Zuschneiden eines metallischen Flächenelements und Ausbilden einer Perforation als manuelle Biegekante wenigstens im Bereich eines ersten Seitenrandes,
- mechanisches Abkanten wenigstens entlang des ersten Seitenrandes, so dass eine erste Biegekante gebildet wird,
- mechanisches Abkanten entlang einer zur ersten Biegekante benachbarten zweiten Biegekante, wobei die Perforation zwischen der ersten Biegekante und der zweiten Biegekante angeordnet ist,
- Biegen entlang der manuellen Biegekante, so dass ein als Hohlraum ausgebildetes Verstärkungselement geschaffen wird, und
- Schließen des Hohlraums mittels eines Verbindungsverfahrens.

Das erfindungsgemäße Verfahren ermöglicht durch eine Kombination von manuellem und maschinellem Biegen eine einfache Herstellung eines Verstärkungselements an einem Flächenelement, ohne dabei das im Stand der Technik übliche Anschweißen eines Hutprofils vornehmen zu müssen. Demnach wird die Gefahr von Verspannungen durch beim Schweißen auftretende lokale Wärmeübertragungen vermieden. Desweiteren ist kein aufwändiges Reinigen mehr nötig, wobei zusätzlich entlang der Perforation auch eine Hinterlüftung des Hohlraums des Verstärkungselements durchgeführt werden kann. Das erfindungsgemäße Verfahren ermöglicht somit in einem einzigen Herstellungsschritt lediglich durch Biegen und Fixieren auf der Rückseite des Flächenelements das Bilden eines Hohlraums als Verstärkungselement. Demnach wird die Herstellung von Verkleidungselementen insbesondere für Schaltschränke oder Maschinenverkleidungen stark vereinfacht, was zu einer Reduzierung der Herstellungskosten führt.

Gemäß einer weiteren Ausführungsform des erfindungsgemäßen Verfahrens wird zur Bildung einer streifenförmigen Fortsetzung eine dritte Biegekante gebildet, wobei mittels des Verbindungsverfahrens, insbesondere mittels Punktschweißens die streifenförmige Fortsetzung mit einer Rückseite des Flächenelements verbunden wird.

Gemäß einer weiteren Ausführungsform des erfindungsgemäßen Verfahrens werden die Perforation und das Zuschneiden des metallischen Flächenelements vorzugsweise in einem Arbeitsschritt mittels eines Laserschneidverfahrens erzeugt.

Demnach werden das Zuschneiden des metallischen Flächenelements und das Bilden der Perforation in einem Schritt durchgeführt, was die Herstellungsdauer, den Aufwand und somit die Kosten von Verkleidungselementen insbesondere für Schaltschränke oder Maschinenverkleidungen stark reduziert. Als Laser können sogenannte Flachbettlaser verwendet werden, die in der industriellen Teilefertigung weit verbreitet sind. Ein derartiger Laser kann sowohl die Umrisse des blechförmigen Ausgangsmaterials als auch die für die Perforation benötigten Öffnungen in einem Arbeitsgang mit hoher Präzision ausbilden.

Des Weiteren wird eine Maschinenverkleidung angegeben, die ein oder mehrere Verkleidungselemente wie oben beschrieben aufweist.

Schließlich wird ein Schaltschrank angegeben, der ein oder mehrere Verkleidungselemente wie oben beschrieben aufweist.

Nachfolgend werden einige Ausführungsbeispiele anhand der Zeichnung näher erläutert. Es zeigen:
- Fig. 1: ein Ausschnitt eines erfindungsgemäßen Verkleidungselements in einer perspektivischen Seitenansicht,
- Fig. 2: eine weitere Seitenansicht des Verkleidungselements gemäß Fig. 1,
- Fig. 3: eine weitere Ausführungsform eines Verkleidungselements gemäß der Erfindung in einer Draufsicht vor Bearbeitung,
- Fig. 4: das Verkleidungselement gemäß Fig. 3 nach Bearbeitung in einer Draufsicht,
- Fig. 5: das Verkleidungselement gemäß Fig. 4 in einer Seitenansicht,
- Fig. 6: eine Detailansicht des Verkleidungselements nach Fig. 5,
- Fig. 7: eine weitere Detailansicht des Verkleidungselements nach Fig. 5,
- Fig. 8: ein Verkleidungselement in einer weiteren Ausführungsform in einer perspektivischen Seitenansicht von einer Vorderseite,
- Fig. 9: das Verkleidungselement gemäß Fig. 8 in einer rückwärtigen Ansicht und
- Fig. 10: ein Detail des Verkleidungselements gemäß Fig. 9.

In den Figuren sind gleiche oder funktional gleich wirkende Bauteile mit den gleichen Bezugszeichen versehen.

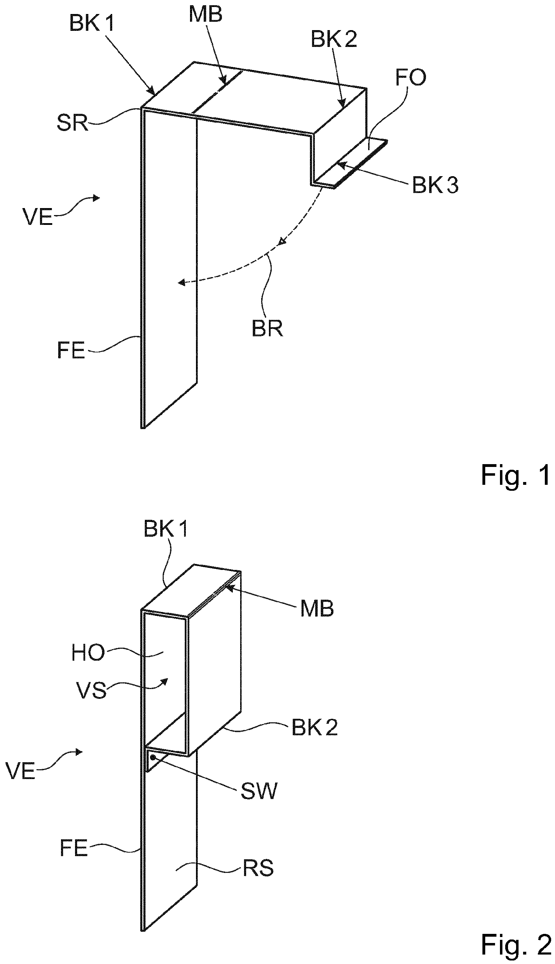

Im Folgenden wird unter Bezugnahme auf Fig. 1 eine erste Ausführungsform der Erfindung näher erläutert.

Fig. 1 zeigt ein Verkleidungselement VE in einer teilweise geschnittenen perspektivischen Seitenansicht. Das Verkleidungselement VE weist ein metallisches Flächenelement FE auf, das in Fig. 1 lediglich als Streifen dargestellt ist. Beispielsweise bei der Herstellung von Wandpaneelen im Rahmen der industriellen Teilefertigung würde das Flächenelement FE entsprechend größer gewählt werden. Desweiteren weist das Verkleidungselement VE eine durch maschinelles Abkanten gebildete erste Biegekante BK1 auf, die üblicherweise das Flächenelement FE seitlich begrenzt. Desweiteren weist das Verkleidungselement FE eine zweite Biegekante BK2 auf, die ebenfalls maschinell herstellbar ist. Das der zweiten Biegekante BK2 folgende Stück des Verkleidungselements VE kann beispielsweise entlang einer dritten Biegekante BK3 erneut maschinell in eine entgegengesetzte Richtung abgekantet werden. Demnach entsteht eine streifenförmige Fortsetzung FO, die sich an die dritte Biegekante BK3 anschließt.

Zwischen der ersten Biegekante BK1 und der zweiten Biegekante BK2 ist eine Perforation PE gebildet, die bereits während des Zuschneidens des metallischen Flächenelements FE im gleichen Arbeitsschritt mittels eines Laserstrahls erzeugt wird. Das maschinelle Abkanten entlang der ersten Biegekante BK1, der zweiten Biegekante BK2 und der dritten Biegekante BK3 kann insbesondere in einem rechten Winkel ausgeführt werden, so dass sich nach manuellem Biegen entlang der manuellen Biegekante MB ein Hohlraum HO bildet, wie in Fig. 2 gezeigt ist. Das manuelle Biegen entlang der manuellen Biegekante MB folgt dabei einer durch das Bezugszeichen BR gekennzeichneten Biegerichtung.

Bei rechtwinkligen Biegungen entlang der Biegekanten BK1, BK2, BK3 und MB wird somit ein rechteckförmiger Hohlraum HO als Verstärkungselement VS gebildet. Um den Hohlraum HO des Verstärkungselements VS zu schließen, kann entlang der streifenförmigen Fortsetzung FO mittels Punktschweißung eine Verbindung mit dem Flächenelement FE geschaffen werden. Aufgrund des nur geringen Wärmeeintrags treten keine Verspannungen im Flächenelement FE auf. Die Verbindung der streifenförmigen Fortsetzung FO mittels Punktschweißung mit dem Flächenelement FE ist in Fig. 2 schematisch mittels eines Schweißpunktes SW dargestellt.

Es ist jedoch auch möglich, die Biegungen entlang der Biegekanten BK1, BK2, BK3 und MB nicht rechtwinkligen auszuführen. Die Biegungen entlang der Biegekanten BK1, BK2, BK3 und MB müssen jedoch so ausgeführt werden, dass ein geschlossener Hohlraum HO als Verstärkungselement VS gebildet wird. Hierbei kann auch ein trapezförmiger Querschnitt des Hohlraums geschaffen werden, wobei andere Ausführungen, wie beispielsweise das eines unregelmäßigen Vielecks, nicht ausgeschlossen sind.

Das erfindungsgemäße Verkleidungselement VE nutzt somit auf vorteilhafte Weise eine Kombination von maschinellem Abkanten und manuellem Biegen, um ein geschlossenes Profil als Verstärkungselement VS zu bilden. Dieses sorgt im Bereich eines Seitenrandes SR des Verkleidungselements VE für eine Verbesserung der mechanischen Stabilität, die ähnlich auch durch Hutprofile im Stand der Technik erreicht wird.

Im Gegensatz dazu ist hier jedoch nur ein geringer Wärmeeintrag beim Verbinden des Flächenelements FE mit der streifenförmigen Fortsetzung FO nötig, so dass keine Verspannungen im Verkleidungselement VE auftreten. Aufgrund der Perforation PE ist auch der Hohlraum HO nicht vollständig geschlossen, so dass eventuell anfallendes Kondenswasser vor einem Lackieren oder Pulverbeschichten des Verkleidungselements VE durch die Perforation PE entweichen können. Demgemäß werden aufwändige Trocknungsschritte, wie sie nach einem Behandeln mit Reinigungsflüssigkeiten bei konventionellen Verkleidungen mit aufgeschweißten Hutprofilen vorgenommen werden müssen, weitestgehend vermieden, was eine kostengünstige Herstellung eines Verkleidungselements VE in wenigen Bearbeitungsschritten ermöglicht. Die Fortsetzung FO kann aber auch anstelle der streifenförmigen Ausgestaltung mehrere Laschen oder trapezförmige Elemente aufweisen, an denen die entsprechenden Schweißpunkte SW gesetzt werden können.

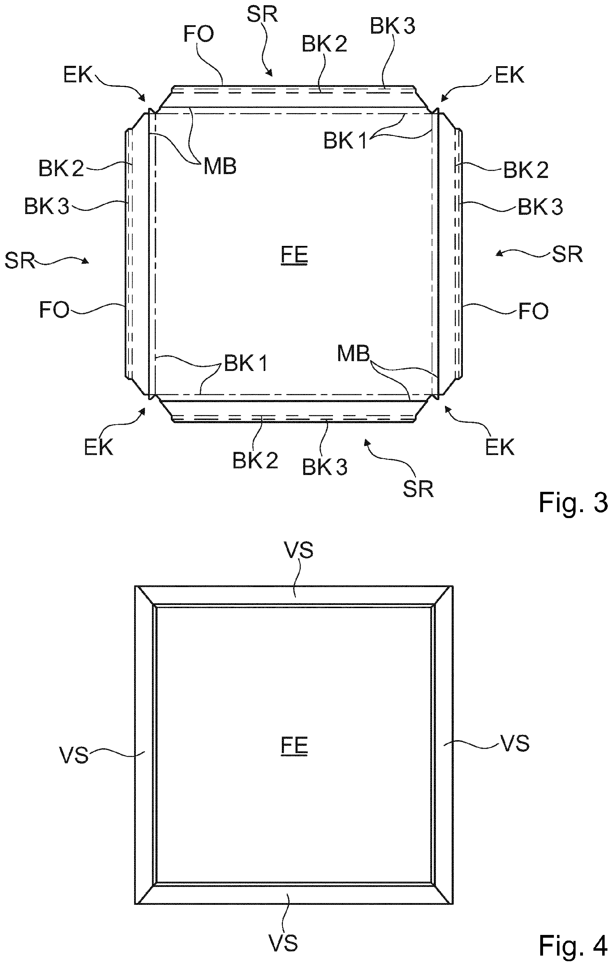

Unter Bezugnahme auf Fig. 3 wird nachfolgend eine weitere Ausführungsform des erfindungsgemäßen Verkleidungselements VE sowie ein erfindungsgemäßes Verfahren zur Herstellung eines Verkleidungselements VE näher beschrieben. Fig. 3 zeigt in einer Draufsicht ein in Form eines Blechpaneels ausgebildetes Verkleidungselement VE, das ein rechteckförmiges Flächenelement FE umfasst, das an allen vier Seitenrändern SR jeweils von einer ersten Biegekante BK1 begrenzt wird. Um beim mechanischen Abkanten oder manuellen Biegen kein Überlapp im Bereich der Ecken EK hervorzurufen, wird das Verkleidungselement VE entsprechend geformt. Als weitere Biegekanten sind zum Außenrand des Verkleidungselements VE hin die manuelle Biegekante MB, die zweite Biegekante BK2 und die dritte Biegekante BK3 jeweils an allen vier Seiten parallel zur ersten Biegekante BK1 angeordnet.

Das Verkleidungselement VE, das beispielsweise aus einem 1 mm bis 2 mm dicken Blech geformt sein kann, wird dann, wie in Fig.1 und Fig. 2 gezeigt wurde, zuerst entlang der ersten Biegekante BK1 und zweiten Biegekante BK2 aus der Zeichenebene herausragend in nahezu rechtem Winkel gekantet. In einer entgegengesetzten Richtung wird das Verkleidungselement VE entlang der dritten Biegekante BK3 ebenfalls maschinell gekantet. Dadurch, dass die manuelle Biegekante MB mittels eines Lasers als Perforation PE bereitgestellt wird, kann hier eine manuelle Biegung vorgenommen werden. Es sei an dieser Stelle nochmals erwähnt, dass ein vollständig mittels maschinellen Kanten ausgebildetes hohlförmiges Profil nicht möglich ist, da beim maschinellen Kanten das Werkzeug anschließend wieder entfernt werden muss, so dass keine geschlossenen Objekte herstellbar sind. Die Perforation PE und das Zuschneiden des metallischen Flächenelements FE werden in einem Arbeitsschritt mittels eines Laserschneidverfahrens beispielsweise durch einen Flachbettlaser erzeugt. Die Perforation PE kann dabei als Loch- oder Schlitzmuster ausgebildet werden, dessen Parameter, wie Wiederholrate, Loch- oder Schlitzabmessungen, Größe der verbleibenden Stege zwischen benachbarten Schlitzen oder ähnliches, an die aktuelle Anwendung im Rahmen von Versuchen angepasst werden muss, wobei beispielsweis die Blechdicke in Betracht gezogen wird. Eine typische Perforation bei einer Blechdicke von ungefähr 1 mm bis 2 mm kann beispielsweise einen Schlitz von ca. 50 mm Länge entlang der manuellen Biegekante MB aufweisen, der mit einer Breite von ca. 0,5 mm bis 1 mm geformt wird. Benachbarte Schlitze können einen ca. 5 mm breiten Steg als Zwischenraum einschließen.

Im Ergebnis erhält man ein Verkleidungselement VE, das in Fig. 4 in einer Draufsicht gezeigt ist. Außerhalb des Flächenelements FE sind nun Versteifungselemente VS ausgebildet, die insbesondere nach einem Befestigen der streifenförmigen Fortsetzung FO nach der dritten Biegekante BK3 als stabiler, rechteckförmiger Hohlraum das Verkleidungselement VE mechanisch stabilisieren. Das erfindungsgemäße Verfahren vermeidet dabei das Übertragen größerer Wärmemengen in einen blechförmigen Zuschnitt, so dass keine Verspannungen im Blechmaterial auftreten können, bzw. Verspannungen im Blechmaterial sehr stark reduziert werden, was eine einfache und kostengünstige Herstellung des Verkleidungselements VE ermöglicht.

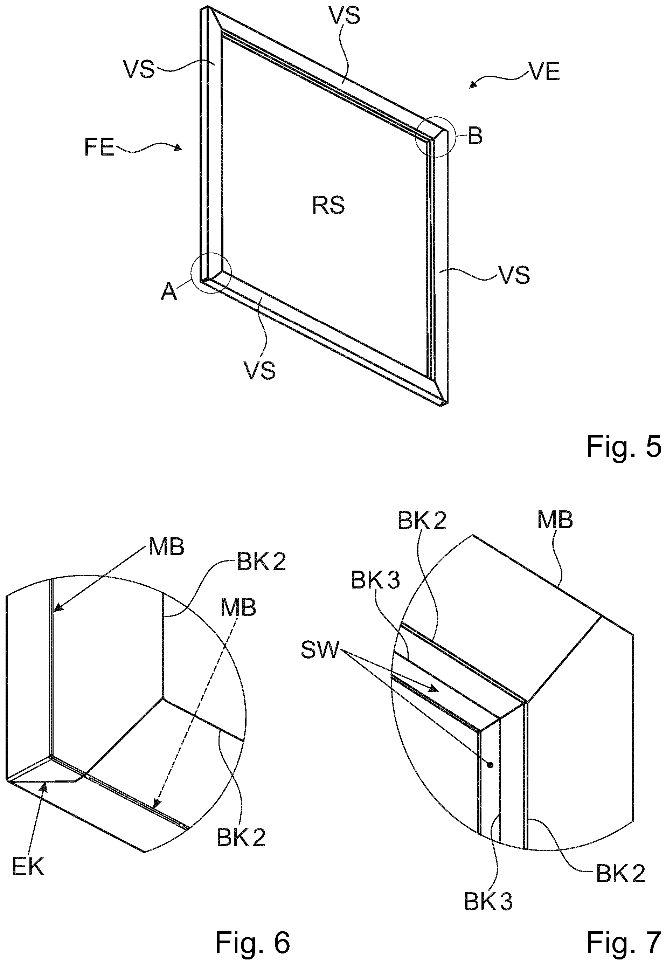

In Fig. 5 ist das Verkleidungselement gemäß Fig. 4 in einer perspektivischen Seitenansicht gezeigt. Man erkennt, dass die entlang der Außenränder gebildeten Verstärkungselemente VS in Form eines rechteckigen Hohlraums das Verkleidungselement VE umgeben.

Die in den beiden Eckbereichen, in Fig. 5 mit A bzw. B gekennzeichnet, ausgebildete Struktur ist in Fig. 6 bzw. 7 nochmals vergrößert dargestellt. Aufgrund der Perforation PE kann die manuelle Biegekante ähnlich eines Scharniers ohne Werkzeug gebogen werden. Die Befestigung der streifenförmigen Fortsetzung FO erfolgt vorzugsweise mittels Punktschweißen an der Rückseite RS des Flächenelements FE. Um einen stabilen Verbund zu bilden, ist es nicht erforderlich, dass an den Ecken nochmals sich berührende Kanten des Blechzuschnitts verschweißt werden. Dies vermindert wiederum den Wärmeeintrag in das Verkleidungselement VE.

Das unter Bezugnahme auf die Figuren 3 bis 7 dargestellte Verkleidungselement VE ist nur beispielhaft zu verstehen. So ist es möglich, Verkleidungselemente VE zu schaffen, die beispielsweise nur an zwei, sich gegenüber liegenden Seiten ein Verstärkungselement VS aufweisen. Ebenso ist es denkbar, das Verkleidungselement VE in einem anderen als einem rechteckförmigen Zuschnitt auszubilden, wobei insbesondere eine quadratische oder trapezförmige Ausgestaltung in Frage kommt. Die Größe des Verkleidungselements VE kann dabei an die jeweilige Anwendung angepaßt werden, so dass diesbezüglich keinerlei Einschränkungen bestehen.

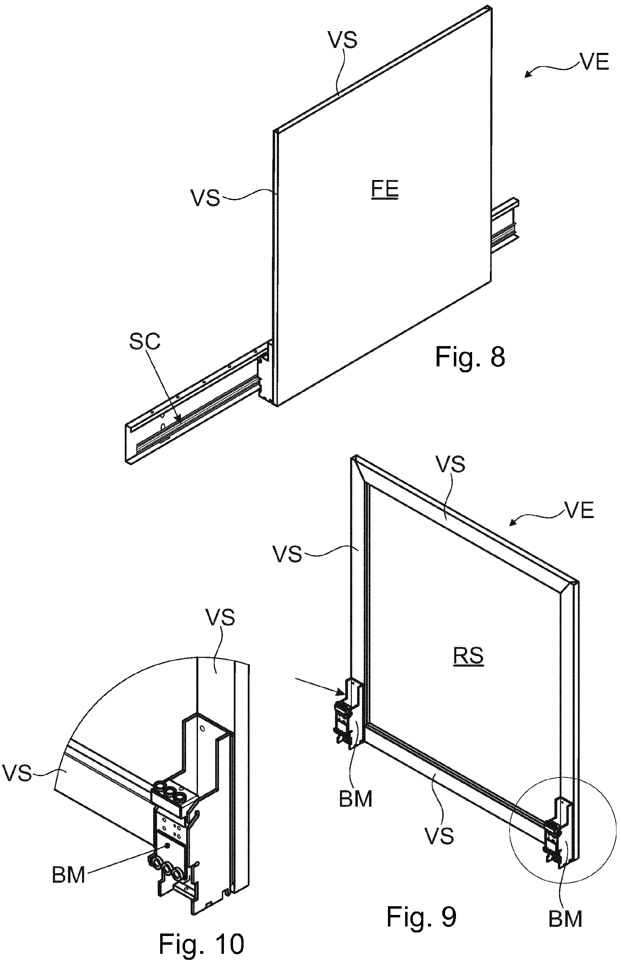

Eine weitere Ausführungsform ist in den Fig. 8 bis 10 gezeigt. In Fig. 8 ist das Verkleidungselement VE von seiner Vorderseite her in einer perspektivischen Seitenansicht gezeigt. Das Verkleidungselement VE weist wiederum das erfindungsgemäße Verstärkungselement VS auf, das entsprechend den Ausführungsformen gemäß Fig. 1 bis 7 gebildet wurde. Das Verkleidungselement VE ist über ein Befestigungsmittel BM in eine in diesem Beispiel horizontal laufende Schiene SC beweglich eingeführt. Dazu wird das Befestigungsmittel BM beispielsweise als Rollenkörper bereitgestellt, der auf die Rückseite des Verkleidungselements VE aufgebracht ist.

Fig. 9 zeigt das Verkleidungselement der Fig. 8 von einer rückwärtigen Ansicht aus. Die als Rollenkörper ausgebildete Befestigungsmittel BM können direkt auf das Verstärkungselement VS beispielsweise mittels Schrauben befestigt werden. Das Verstärkungselement VS sorgt dabei für die mechanische Stabilität des Verkleidungselements VE, so dass ein Bewegen in der Schiene SC so ausgeführt werden kann, wobei nur geringe oder keine Verbiegungen des Verkleidungselements VE auftreten.

Die Fig. 10 zeigt die Befestigung des Rollenkörpers als Befestigungsmittel BM nochmals in einer detaillierten Ansicht. Die direkte Befestigung am Verstärkungselement VS vermeidet somit das Bereitstellen von Bohrungen oder das Anschweißen von Laschen, wie das im Stand der Technik üblicherweise geschieht, um eine Befestigungsmöglichkeit für das Befestigungsmittel BM zu schaffen.

## Patentansprüche

1. Verkleidungselement, insbesondere für eine Maschinenverkleidung oder einen Schaltschrank, das ein metallisches Flächenelement (FE) aufweist, wobei das Flächenelement (FE) wenigstens entlang eines Seitenrands (SR) so geformt ist, dass ein Verstärkungselement (VS) gebildet ist, das einen Hohlraum (HO) umschließt, wobei eine durch Abkanten gebildete erste Biegekante (BK1) das Flächenelement (FE) seitlich begrenzt und eine durch Abkanten gebildete zweite Biegekante (BK2) auf einer Rückseite (RS) des Flächenelements (FE) angeordnet ist, **dadurch gekennzeichnet, dass** zwischen der ersten Biegekante (BK1) und der zweiten Biegekante (BK2) eine Perforation (PE) im Flächenelement (FE) als manuelle Biegekante (MB) gebildet ist und entlang des gesamten Außenumfangs des Flächenelements (FE) weitere Verstärkungselemente (VS) gebildet sind.

2. Verkleidungselement nach Anspruch 1, bei dem sich der zweiten Biegekante (BK2) eine dritte Biegekante (BK3) anschließt, so dass eine vorzugsweise streifenförmige Fortsetzung (FO) parallel zu einer Hauptfläche des Flächenelements (FE) angeordnet ist.

3. Verkleidungselement nach Anspruch 1 oder 2, bei dem die erste Biegekante (BK1), die zweite Biegekante (BK2), die manuelle Biegekante (MB) und gegebenenfalls die dritte Biegekante (BK3) im Wesentlichen parallel zueinander und rechtwinklig angeordnet sind, so dass sich ein rechteckförmiger Hohlraum (HO) bildet.

4. Verkleidungselement nach einem der Ansprüche 1 bis 3, bei dem die Perforation (PE) im Flächenelement (FE) mittels eines Lasers gebildet ist.

5. Verkleidungselement nach einem der Ansprüche 1 bis 4, bei dem die erste Biegekante (BK1) und die zweite Biegekante (BK2) maschinell abkantbar sind.

6. Verkleidungselement nach einem der Ansprüche 1 bis 5, bei dem das Verstärkungselement (VS) auf der Rückseite des Verkleidungselements (VE) mit einer Schienenanordnung (SC) vorzugsweise über ein Befestigungsmittel (BM) mit einer Schraubverbindung verbindbar ist.

7. Verkleidungselement nach einem der Ansprüche 1 bis 6, das als einstückiges Blechbauteil bereitgestellt ist.

8. Verkleidungselement nach einem der Ansprüche 1 bis 7, bei dem im Bereich der zweiten Biegekante (BK2) und/oder der dritten Biegekante (BK3) mittels eines Verbindungsverfahrens, insbesondere mittels Punktschweißens eine Verbindung des Verstärkungselements (VS) zum Flächenelement (FE) herstellbar ist.

9. Verfahren zur Herstellung eines Verkleidungselements (VE), insbesondere für eine Maschinenverkleidung oder einen Schaltschrank, bei dem folgende Schritte ausgeführt werden:
- Zuschneiden eines metallischen Flächenelements (FE) und Ausbilden einer Perforation (PE) als manuelle Biegekante (MB) wenigstens im Bereich eines ersten Seitenrandes (SR),
- mechanisches Abkanten wenigstens entlang des ersten Seitenrandes (SR), so dass eine erste Biegekante (BK1) gebildet wird,
- mechanisches Abkanten entlang einer zur ersten Biegekante (BK1) benachbarten zweiten Biegekante (BK1), wobei die Perforation (PE) zwischen der ersten Biegekante (BK1) und der zweiten Biegekante (BK2) angeordnet ist,
- Biegen entlang der manuellen Biegekante (MB), so dass ein als Hohlraum (HO) ausgebildetes Verstärkungselement (VS) geschaffen wird,
- Schließen des Hohlraums (HO) mittels eines Verbindungsverfahrens, und
- Bilden weiterer Verstärkungselemente (VS) entlang des gesamten Außenumfangs des Flächenelements (FE).

10. Verfahren nach Anspruch 9, bei dem zur Bildung einer streifenförmigen Fortsetzung (FO) eine dritte Biegekante (BK3) gebildet wird, wobei mittels des Verbindungsverfahrens, insbesondere mittels Punktschweißens die streifenförmige Fortsetzung (FO) mit einer Rückseite des Flächenelements (FE) verbunden wird.

11. Verfahren nach Anspruch 9 oder 10, bei dem die Perforation (PE) und das Zuschneiden des metallischen Flächenelements (FE) vorzugsweise in einem Arbeitsschritt mittels eines Laserschneidverfahrens erzeugt werden.

12. Maschinenverkleidung, die ein oder mehrere Verkleidungselemente (VE) nach Anspruch 1 bis 8 aufweist.

13. Schaltschrank, der ein oder mehrere Verkleidungselemente (VE) nach Anspruch 1 bis 8 aufweist.

## Claims

1. Cladding element, in particular for a machine cladding or a switch cabinet, which has a metallic surface element (FE), wherein, at least along a side edge (SR), the surface element (FE) is shaped such that a reinforcement element (VS) which encloses a cavity (HO) is formed, wherein a first bending edge (BK1), formed by folding, laterally delimits the surface element (FE) and a second bending edge (BK2), formed by folding, is arranged on a rear side (RS) of the surface element (FE), **characterized in that** a perforation (PE) in the surface element (FE) is formed as a manual bending edge (MB) between the first bending edge (BK1) and the second bending edge (BK2) and further reinforcement elements (VS) are formed along the entire outer periphery of the surface element (FE) .

2. Cladding element according to Claim 1, in which the second bending edge (BK2) is followed by a third bending edge (BK3), with the result that a preferably strip-shaped continuation (FO) is arranged parallel to a main surface of the surface element (FE).

3. Cladding element according to Claim 1 or 2, in which the first bending edge (BK1), the second bending edge (BK2), the manual bending edge (MB) and, if appropriate, the third bending edge (BK3) are arranged substantially parallel to one another and in a right-angled manner, with the result that a rectangular cavity (HO) is formed.

4. Cladding element according to one of Claims 1 to 3, in which the perforation (PE) in the surface element (FE) is formed by means of a laser.

5. Cladding element according to one of Claims 1 to 4, in which the first bending edge (BK1) and the second bending edge (BK2) are able to be machine-folded.

6. Cladding element according to one of Claims 1 to 5, in which the reinforcement element (VS) on the rear side of the cladding element (VE) is able to be connected to a rail arrangement (SC), preferably via a fastening means (BM) by way of a screw connection.

7. Reinforcement element according to one of Claims 1 to 6, which is provided as a one-piece sheet-metal component.

8. Reinforcement element according to one of Claims 1 to 7, in which, in the region of the second bending edge (BK2) and/or of the third bending edge (BK3), a connection of the reinforcement element (VS) to the surface element (FE) is able to be produced by means of a connection process, in particular by means of spot welding.

9. Method for producing a cladding element (VE), in particular for a machine cladding or a switch cabinet, in which the following steps are carried out:
- cutting to size a metallic surface element (FE) and forming a perforation (PE) as a manual bending edge (MB) at least in the region of a first side edge (SR),
- performing mechanical folding at least along the first side edge (SR) such that a first bending edge (BK1) is formed,
- performing mechanical folding along a second bending edge (BK1), which is adjacent to the first bending edge (BK1), wherein the perforation (PE) is arranged between the first bending edge (BK1) and the second bending edge (BK2),
- performing bending along the manual bending edge (MB) such that a reinforcement element (VS) formed as a cavity (HO) is created,
- closing the cavity (HO) by means of a connection process, and
- forming further reinforcement elements (VS) along the entire outer periphery of the surface element (FE).

10. Method according to Claim 9, in which a third bending edge (BK3) is formed for forming a strip-shaped continuation (FO), wherein the strip-shaped continuation (FO) is connected to a rear side of the surface element (FE) by means of the connection process, in particular by means of spot welding.

11. Method according to Claim 9 or 10, in which the perforation (PE) and the cutting to size of the metallic surface element (FE) are preferably realized in one work step by means of a laser-cutting process.

12. Machine cladding which has one or more cladding elements (VE) according to Claims 1 to 8.

13. Switch cabinet which has one or more cladding elements (VE) according to Claims 1 to 8.

## Revendications

1. Elément d'habillage, en particulier pour habillage de machine ou armoire de commutation, l'élément présentant un élément métallique plat (FE), l'élément plat (FE) étant configuré au moins le long de son bord latéral (SR) de manière à former un élément de renfort (VS) qui englobe une cavité (HO), un premier rabat (BK1) formé par rabattement délimitant latéralement l'élément plat (FE) et un deuxième rabat (BK2) formé par rabattement étant disposé sur le côté arrière (RS) de l'élément plat (FE),
**caractérisé en ce que**
une perforation (PE) est formée dans l'élément plat (FE) entre le premier rabat (BK1) et le deuxième rabat (BK2) sous la forme d'un rabat manuel (MB) et
**en ce que** d'autres éléments de renfort (VS) sont formés sur toute la périphérie extérieure de l'élément plat (FE).

2. Elément d'habillage selon la revendication 1, dans lequel le deuxième rabat (BK2) est adjacent à un troisième rabat (BK3) de telle sorte qu'un prolongement (FO) de préférence en forme de ruban soit disposé parallèlement à une surface principale de l'élément plat (FE).

3. Elément d'habillage selon les revendications 1 ou 2, dans lequel le premier rabat (BK1), le deuxième rabat (BK2), le rabat manuel (MB) et éventuellement le troisième rabat (BK3) sont disposés essentiellement en parallèle les uns aux autres et à angle droit de manière à former une cavité (HO) de forme rectangulaire.

4. Elément d'habillage selon l'une des revendications 1 à 3, dans lequel la perforation (PE) est formée dans l'élément plat (FE) au moyen d'un laser.

5. Elément d'habillage selon l'une des revendications 1 à 4, dans lequel le premier rabat (BK1) et le deuxième rabat (BK2) peuvent être rabattus par machine.

6. Elément d'habillage selon l'une des revendications 1 à 5, dans lequel l'élément de renfort (VS) peut être relié à un ensemble de rail (SC), de préférence par l'intermédiaire d'un moyen de fixation (BM), sur le côté arrière de l'élément d'habillage (VE).

7. Elément d'habillage selon l'une des revendications 1 à 6, configuré sous la forme d'un composant en tôle d'un seul tenant.

8. Elément d'habillage selon l'une des revendications 1 à 7, dans lequel une liaison peut être établie entre l'élément de renfort (VS) et l'élément plat (FE) au niveau du deuxième rabat (BK2) et/ou du troisième rabat (BK3) au moyen d'un procédé de liaison et en particulier par soudage par points.

9. Procédé de fabrication d'un élément d'habillage (VE), en particulier pour un habillage de machine ou une armoire de commutation, dans lequel les étapes suivantes sont réalisées :
découpe d'un élément plat (FE) métallique et formation d'une perforation (PE) en tant que rabat manuel (MB) manuel, au moins au niveau d'un premier bord latéral (SR),
rabattement mécanique au moins le long du (SR) de manière à former un premier rabat (BK1),
rabattement mécanique le long d'un deuxième rabat (BK1) voisin du premier rabat (BK1), la perforation (PE) étant disposée entre le premier rabat (BK1) et le deuxième rabat (BK2),
rabattement le long du rabat manuel (MB) de manière à créer un élément de renfort (VS) configuré comme cavité (HO),
fermeture de la cavité (HO) au moyen d'une opération de liaison et
formation d'autres éléments de renfort (VS) sur toute la périphérie extérieure de l'élément plat (FE).

10. Procédé selon la revendication 9, dans lequel un troisième rabat (BK3) est formé en vue d'obtenir un prolongement (FO) en forme de ruban, le prolongement (FO) en forme de ruban étant relié à un côté arrière de l'élément plat (FE) au moyen de l'opération de liaison et en particulier par soudage par points.

11. Procédé selon les revendications 9 ou 10, dans lequel la perforation (PE) et la découpe de l'élément plat (FE) sont réalisées de préférence en une étape de travail au moyen d'une opération de découpe au laser.

12. Habillage de machine présentant un ou plusieurs éléments d'habillage (VE) selon les revendications 1 à 8.

13. Armoire de commutation présentant un ou plusieurs éléments d'habillage (VE) selon les revendications 1 à 8.
